# EUROPÄISCHE PATENTSCHRIFT

(11) **EP 0 417 638 B1**
(45) Veröffentlichungstag und Bekanntmachung des Hinweises auf die Patenterteilung: **28.12.1994**
(21) Anmeldenummer: 90117156.1
(22) Anmeldetag: 06.09.1990
(51) Int. Cl.: H01J 37/063, H01J 3/40, H01J 37/04

(54) **Elektronenstrahlerzeuger, insbesondere für eine Elektronenstrahlkanone**
Electron beam producing device, particularly for an electron gun
Dispositif de production d'un faisceau d'électrons, en particulier pour canon à électrons

(30) Priorität: 09.09.1989 DE 3930198
(43) Veröffentlichungstag der Anmeldung: 20.03.1991
(73) Patentinhaber: PTR PRÄZISIONSTECHNIK GMBH, 63461 Maintal (DE)
(72) Erfinder: Fritz, Dieter, D-6460 Gelnhausen (DE)
(74) Vertreter: Sartorius, Peter, Dipl.-Ing.

(56) Entgegenhaltungen:
- CH-A- 340 924
- US-A- 4 625 150
- PATENT ABSTRACTS OF JAPAN, Band 12, Nr. 234 (E-629)[3081], 5th July 1988;& JP-A-63 26 938

## Beschreibung

Die Erfindung betrifft einen Elektronenstrahlerzeuger, insbesondere für eine Elektronenstrahlkanone, bei dem in einem evakuierbaren Gehäuse eine Glühkathode, eine Steuerelektrode und eine mit dem Gehäuse auf Massepotential liegende Anode mit einer Bohrung zum Eintritt des Elektronenstrahls in die Arbeitskammer der folgenden Apparatur vorgesehen sind.

Ein Elektronenstrahlerzeuger dieser Art ist aus der DE-OS 33 28 172 bekannt. Bei Elektronenstrahlerzeugern dieser Art wird der Elektronenstrahl auf der Strecke zum Werkstück oder Tiegel in der Arbeitskammer durch den Raumladungseffekt verbreitert. Dieser Effekt wird mehr oder weniger stark kompensiert durch die Ionisierung der restlichen Gasmoleküle im Vakuum, wobei der Grad der Kompensation vom Druck des Vakuums abhängig ist. Dies hat zur Folge, daß die Strahleigenschaften, wie Fleckgröße, Fokuslage und Leistungsdichte, druckabhängigen Schwankungen unterworfen sind, die besondere Steuerungsmaßnahmen erfordern und das Anfahren von Bearbeitungsvorgängen verzögern.

Ferner ist aus der japanischen Druckschrift (Patent Abstracts of Japan, Band 12, Nr. 234 (E-629) [3081] vom 5. Juli 1988) bekannt, einen Elektronenstrahlerzeuger mit einem Wahlschalter 40 auszustatten, mittels dessen die lonenfalle lediglich an negative Spannung oder an Massepotential angelegt werden kann.

Es sind auch Elektronenstrahlerzeuger bekannt, bei denen die Anode auf einem positiven Potential in Höhe von etwa 10 % der Beschleunigungsspannung liegt. Diese sind jedoch sehr aufwendig, da sie eine zusätzliche Isolierung und eine Hochspannungsversorgung für die Anode benötigen.

Der Erfindung liegt die Aufgabe zugrunde, bei einem Elektronenstrahlerzeuger der eingangs genannten Art die Strahleigenschaften zu stabilisieren und ihre Druckabhängigkeit zu vermindern.

Erfindungsgemäß wird diese Aufgabe dadurch gelöst, daß der Anode ein zu ihr koaxial angeordneter Potentialring benachbart ist, der auf einem gegenüber dem Anodenpotential positiven Potential liegt, wobei der Potentialring in Form einer Hülse in einem Abschnitt der Anodenbohrung in Strahlrichtung hinter der Anode angeordnet ist und die Potentialdifferenz zwischen der Anode und dem Potentialring 30 Volt oder mehr beträgt. Durch die vorteilhafte Anordnung und Ausbildung des Elektronenstrahlerzeugers, insbesondere der Elektronenstrahlkanone, wird auf kostengünstige Weise verhindert, daß die vom Elektronenstrahl erzeugten Ionen im Beschleunigungsfeld der Elektronen zur Kathode hin beschleunigt und auf diese Weise aus dem Strahlbereich abgesaugt werden. Die zur Kompensation des Raumladungseffekts erforderliche Ionisierungsdichte kann dadurch über einen weiten Druckbereich aufrechterhalten werden, so daß neben der Fleckgröße die axiale Fokuslage und die Strahldichte in diesem Druckbereich weitgehend konstant bleiben.

Mit der erfindungsgemäßen Anordnung werden also die Ionen im Elektronenstrahlbereich bleiben, damit der Strahl durch die Ionen kompensiert werden kann, ohne daß die Ionen in den Beschleunigungsraum abfließen können. Deshalb ist es besonders vorteilhaft, daß die Anode, die mit dem Gehäuse fest verbunden ist, auf Erdpotential liegt, während der Potentialring, der erfindungsgemäß in Strahlrichtung hinter der Anode in Form einer Hülse im Abschnitt der Anodenbohrung vorgesehen ist, auf positiver Spannung gegenüber der Anode liegt. Durch diese geometrische Anordnung wird verhindert, daß der Potentialring durch den Elektronenstrahl getroffen wird, d. h. der Potentialring ist auf vorteilhafte Weise geschützt. Hierdurch ist es auch möglich, daß der Potentialring an einer Spannungsquelle anliegen kann, die nur den Strom zu liefern hat, der dem Ionenstrom entspricht. Hierdurch besteht die Möglichkeit, im µ-Ampere-Bereich zu arbeiten, so daß mit einer ganz geringen Leistung ausgekommen werden kann. Hierdurch kann also der Potentialring als Potentialsperre eingesetzt werden. In vorteilhafter Weise wird an den Potentialring eine positive Gleichspannung von über 30 Volt angelegt. Dadurch kann im Druckbereich von 10⁻³ bis 10⁻⁵ mbar eine Abnahme der Ionendichte auf der Strecke zum Werkstück und damit eine unzureichende Kompensation des Raumladungseffekts vermieden werden, so daß die Fokuslage, die Größe des Brennflecks im Fokus und die Leistungsdichte des Elektronenstrahls in dem angegebenen Druckbereich im wesentlichen konstant bleiben. Die Steuerung der Elektronenstrahlkanone wird dadurch sehr vereinfacht, und eine aufwendige Regelung des Vakuumdrucks wird entbehrlich.

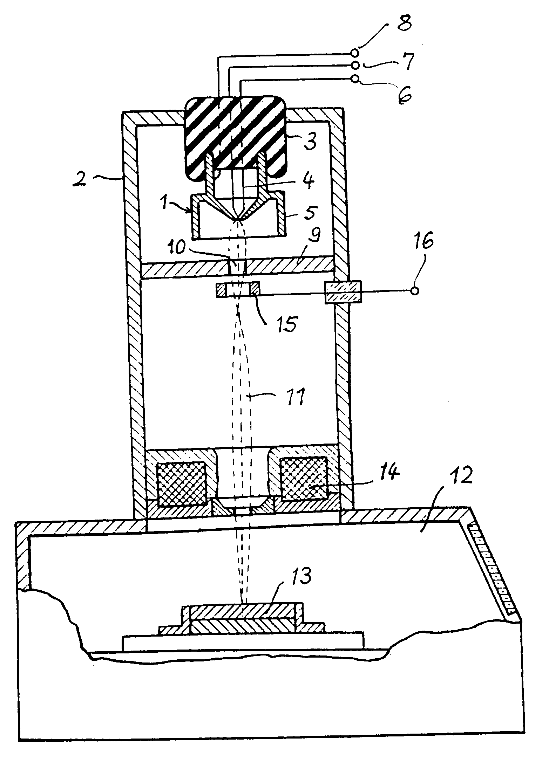

Die Erfindung wird nachfolgend anhand eines in der Zeichnung dargestellten Ausführungsbeispiels näher erläutert. Die Zeichnung zeigt im Schnitt das Schema einer Elektronenstrahlkanone zum Bearbeiten eines Werkstücks.

Die einzige Figur zeigt einen Elektronenstrahlerzeuger 1, der ein an Masse liegendes Gehäuse 2 aufweist, in dem an einem Isolator 3 eine Glühkatode 4 und eine Steuerelektrode 5 angeordnet sind. Die Katode 4 wird über elektrische Anschlüsse 6, 7 mit einem Heizstrom versorgt. Die Spannungsversorgung der Steuerelektrode 5 erfolgt über einen Anschluß 8. Eine Beschleunigungsanode 9 mit einer zentralen Bohrung 10 ist Teil des Gehäuses 2 und liegt somit ebenfalls an Masse. Mit dieser an sich bekannten Anordnung wird bei Anlegung einer entsprechenden Spannung ein Elektronenstrahl 11 erzeugt, der durch die Bohrung 10 in eine Arbeitskammer 12 gelangt, um dort an einem Werkstück 13 z. B. einen Schweißvorgang auszuführen. Das Gehäuse 2 und die Arbeitskammer 12 sind dabei evakuiert. Auf der Strecke zum Werkstück 13 wird der Elektronenstrahl 11 von einer Spule 14 derart fokussiert, daß am Werkstück 13 eine hohe Strahldichte erreicht wird und der Brennpunkt des Elektronenstrahls 14 sich dabei unmittelbar an der Bearbeitungsstelle des Werkstücks 13 befindet.

Um die gewünschte Fokuslage und die Dichte des Elektronenstrahls 11 zu stabilisieren, ist in Strahlrichtung hinter der Anode 9 konzentrisch zu dieser ein Potentialring 15 angeordnet, an den über einen Anschluß 16 eine positive Gleichspannung von über 30 Volt angelegt wird. Hierdurch kann in einem Druckbereich von 10⁻³ bis 10⁻⁵ eine Abnahme der Ionisierungsdichte auf der Strecke zum Werkstück und damit eine unzureichende Kompensation des Raumladungseffekts vermieden werden, so daß die Fokuslage, die Größe des Brennflecks im Fokus und die Leistungsdichte des Elektronenstrahls in dem angegebenen Druckbereich im wesentlichen konstant bleiben. Die Steuerung der Elektronenstrahlkanone wird dadurch wesentlich vereinfacht und eine aufwendige Regelung des Vakuumdrucks wird entbehrlich. Weiterhin können Bearbeitungsvorgänge ohne Nachteil bereits vor Erreichen eines konstanten Minimaldrucks begonnen werden.

## Patentansprüche

1. Elektronenstrahlerzeuger, insbesondere für eine Elektronenstrahlkanone, bei dem in einem evakuierbaren Gehäuse (2) eine Glühkathode (4), eine Steuerelektrode (5) und eine mit dem Gehäuse auf Massepotential liegende Anode (9) mit einer Bohrung (10) zum Eintritt des Elektronenstrahls (11) in die Arbeitskammer der folgenden Apparatur vorgesehen sind, **dadurch gekennzeichnet, daß** der Anode (9) ein zu ihr koaxial angeordneter Potentialring (15) benachbart ist, der auf einem gegenüber dem Anodenpotential positiven Potential liegt, wobei der Potentialring (15) in Form einer Hülse in einem Abschnitt der Anodenbohrung in Strahlrichtung hinter der Anode (9) angeordnet ist und die Potentialdifferenz zwischen der Anode (9) und dem Potentialring (15) 30 Volt oder mehr beträgt.

## Claims

1. Electron beam generator, particularly for an electron gun where there are provided in an evacuable housing (2) a hot cathode (4), a control electrode (5) and an anode (9) which together with the housing is connected to ground, this anode having a bore (10) for the electron beam (11) to enter the working chamber of the subsequent apparatus, characterized in that a potential ring (15), which is at a positive potential as compared to the anode potential, is located adjacent to the anode (9) and disposed coaxially thereto, that said potential ring (15) is in the form of a sleeve located in a section of the anode bore behind the anode (9) in the direction of the beam, and that the potential difference between the anode (9) and the potential ring (15) is 30 volts or more.

## Revendications

1. Générateur de faisceaux électroniques destiné notamment à un canon à électrons et comportant un boîtier (2) pouvant être mis sous vide dans lequel sont prévus une cathode à incandescence (4), une électrode de commande (5) et une anode (9) qui est mise à la terre avec le boîtier et présente un alésage (10) permettant l'entrée du faisceau électronique (11) dans la chambre de travail de l'appareillage suivant, caractérisé en ce qu'un anneau de potentiel (15) voisin de l'anode (9) est disposé de façon coaxiale par rapport à cette dernière et est à un potentiel positif par rapport à celui de l'anode, ledit anneau de potentiel (15) en forme de douille étant disposé dans une section de l'alésage de l'anode dans le sens du faisceau derrière l'anode (9), et la différence de potentiel entre l'anode (9) et l'anneau de potentiel (15) étant de 30 volts ou davantage.
